# EUROPEAN PATENT APPLICATION

(11) **EP 4 567 872 A2**
(43) Date of publication of application: **11.06.2025**
(21) Application number: 25169453.5
(22) Date of filing: 09.04.2025
(51) Int. Cl.: H01L 21/67, H01L 21/683, H01L 21/687

(54) **MATERIAL REMOVAL APPARATUS AND METHODS OF REMOVING MATERIAL FROM AN OBJECT SUPPORT**

(71) Applicant: ASML Netherlands B.V., 5500 AH Veldhoven (NL)
(72) Inventor: KOEVOETS, Adrianus, Hendrik, 5500 AH Veldhoven (NL); VAN HAL, Paulus, Albertus, 5500 AH Veldhoven (NL)
(74) Representative: ASML Netherlands B.V.

(57) **Abstract**

Disclosed is a material removal apparatus and a method of material removal using the apparatus. The apparatus comprises a chamber for receiving an object from which material is to be removed. The apparatus further comprises a chemical assistant source being operable to provide a chemical assistant within the chamber, a radiation source for generating at least one radiation beam for locally photodissociating the chemical assistant only at one or more removal regions of said object, and an ion beam source for providing at least one ion beam at the one or more removal regions to remove material from said one or more removal regions.

## Description

### FIELD

The present invention relates to material removal apparatuses and methods used in the manufacture of object supports. The object supports, such as a reticle support or wafer/substrate support, may be used in lithographic apparatuses.

### BACKGROUND

A lithographic apparatus is a machine constructed to apply a desired pattern onto a substrate. A lithographic apparatus can be used, for example, in the manufacture of substrates comprising integrated circuits (ICs). A lithographic apparatus may, for example, project a pattern at a patterning device (e.g., a mask) onto a layer of radiation-sensitive material (resist) provided on a substrate.

To project a pattern on a substrate, a lithographic apparatus may use electromagnetic radiation. The wavelength of this radiation determines the minimum size of features, which can be formed on the substrate. The lithographic apparatus may use deep-ultra violet (DUV) exposure light, having a wavelength of 436 nm (g-line) or 365 nm (i-line) or 248 nm (KrF) or 193 nm (ArF), or may use extreme ultraviolet (EUV) radiation, having a wavelength within the range 4 to 20 nm, for example 6.7 nm or 13.5 nm.

To project a pattern onto a radiation sensitive material on a substrate (e.g., a semiconductor wafer) a patterning device, typically referred to as the "mask" or "reticle" (all three terms are synonymous), is used to pattern a radiation beam. The patterned radiation beam is then used to expose a portion of the substrate. Each of the patterning device and substrate is supported by a respective object support, i.e., a patterning device support and a substrate support.

It is known to provide the contact surfaces of such a support with a hard coating, e.g., a diamond or other carbon-based layer coating, which reduces wear and therefore increase the time between service intervals for replacing/maintaining the support. Such a coating may require a removal step, e.g., an etch step, to remove some of the hard coating and configure (e.g., flatten) the contact surface or other surface of the object support, during the manufacturing process. In this context, the contact surface may comprise a surface that contacts the object supported by the object support, e.g., burl top surfaces configured to support the object.

It would be desirable to improve methods of treating a surface, e.g., a coated surface, of an object support such as a reticle or wafer support. Such an object support may be an electrostatic object support or vacuum object support, which retain the object electrostatically or with a vacuum, respectively.

### SUMMARY

In a first aspect of the invention, there is provided a material removal apparatus, comprising a chamber for receiving an object from which material is to be removed. The apparatus further comprises a chemical assistant source being operable to provide a chemical assistant within the chamber, a radiation source for generating at least one radiation beam for locally photodissociating the chemical assistant only at one or more removal regions of said object, and an ion beam source for generating at least one ion beam at the one or more removal regions to remove material from said one or more removal regions.

In a second aspect of the invention, there is provided a method for removing material from one or more removal regions on an object support. The method comprises: providing a chemical assistant, irradiating said one or more removal regions to locally photodissociate the chemical assistant only at the one or more removal regions of said object, generating at least one ion beam, and directing the at least one ion beam at the one or more removal regions to remove material from said one or more removal regions.

In a third aspect of the invention, there is provided an object support comprising one or more contact surfaces having been flattened using the method of the second aspect.

### BRIEF DESCRIPTION OF THE DRAWINGS

Embodiments of the invention will now be described, by way of example only, with reference to the accompanying schematic drawings, in which:
- Figure 1 depicts an illustration of a lithographic system comprising a lithographic apparatus and a radiation source;
- Figure 2 is a side view schematic illustration of an electrostatic support; and
- Figure 3 is a schematic illustration of a material removal apparatus according to concepts disclosed herein.

### DETAILED DESCRIPTION

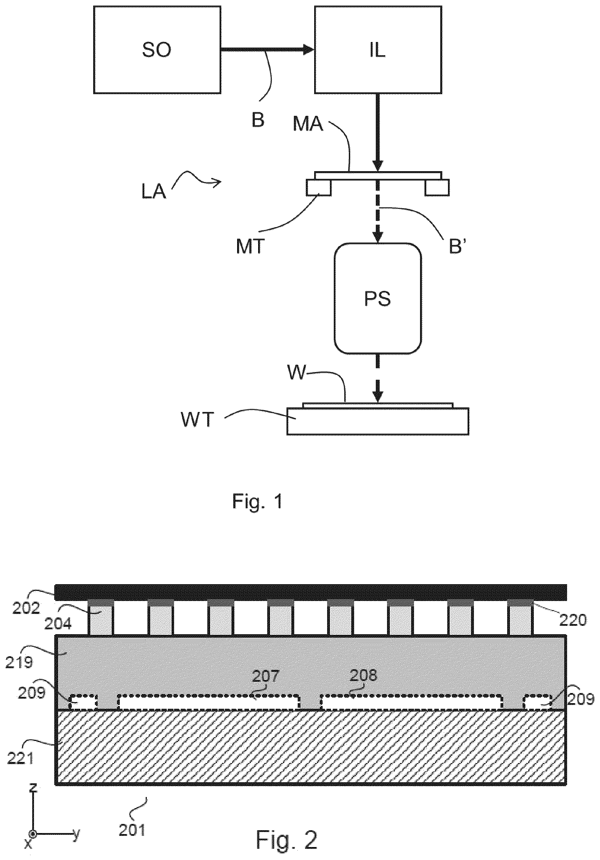

Figure 1 shows a lithographic system comprising a radiation source SO and a lithographic apparatus LA. The radiation source SO is configured to generate an exposure radiation beam B and to supply the exposure radiation beam B to the lithographic apparatus LA. The lithographic apparatus LA comprises an illumination system IL, a support structure MT (or reticle stage) configured to support a patterning device MA (e.g., a mask or reticle), a projection system PS and a substrate table WT (a wafer table or a substrate holder) configured to support a substrate W (e.g., a resist coated semiconductor wafer).

The illumination system IL is configured to condition the exposure radiation beam B before the exposure radiation beam B is incident upon the patterning device MA. Thereto, the illumination system IL may include optical elements. The optical elements provide the exposure radiation beam B with a desired cross-sectional shape and a desired intensity distribution. The illumination system IL may include other devices in addition to the optical elements.

After being conditioned by the illumination system IL, the exposure radiation beam B interacts with the patterning device (or reticle) MA. The support structure MT, hereafter a reticle stage, may support the patterning device MA by clamping it electrostatically or by a vacuum, and may be configured to scan the patterning device MA during exposures. The reticle stage WT may have an array of projections, referred to as burls, projecting from at least one side reticle stage body. As a result of the interaction of exposure radiation beam B and patterning device MA, a patterned exposure radiation beam B' is generated. The projection system PS is configured to project the patterned exposure radiation beam B' onto a substrate W held by the substrate table WT. The projection system PS may apply a reduction factor to the patterned exposure radiation beam B', thus forming an image with features that are smaller than corresponding features on the patterning device MA. For example, a reduction factor of 2, 4 or 8 may be applied.

The substrate W may include previously formed patterns. Where this is the case, the lithographic apparatus LA aligns the image, formed by the patterned exposure radiation beam B', with a pattern previously formed on the substrate W.

The substrate W to be exposed may be supported by a substrate holder WT (i.e., the object that directly supports a substrate), which in turn is supported by a position module (not illustrated in Figure 1) for moving the substrate holder WT relative to the patterned radiation beam B', for example. The substrate holder WT may have an array of projections, referred to as burls, projecting from at least one side. When the substrate W rests on the top of the burls on the at least one side of the substrate holder WT, the substrate W may be spaced apart from a main body of the substrate holder WT. This may aid in the prevention of a particle (i.e., a contaminating particle such as a dust particle), which may be present on the substrate holder WT, from distorting the substrate holder WT or substrate W. The total surface area of the burls may only correspond to a small fraction of the total area of the substrate W or substrate holder WT. As such, it is more probable that any particle will lie between burls and its presence will have no effect.

Due to high accelerations that may be experienced by the substrate W in use of a high-throughput lithographic apparatus, it may be insufficient to allow the substrate W simply to rest on the burls of the substrate holder WT. Instead, the substrate W is clamped in place. Two methods of clamping the substrate in place may be used: vacuum clamping and electrostatic clamping. In vacuum clamping, the space between the substrate holder WT and substrate W and optionally between the substrate table WT and substrate holder are partially evacuated so that the substrate W is held in place by the higher pressure of gas or liquid above it. Vacuum clamping, however, may not be used where the beam path and/or the environment near the substrate W or substrate holder WT is kept at a low or very low pressure, e.g., for extreme ultraviolet (EUV) radiation lithography. In this case, it may not be possible to develop a sufficiently large pressure difference across the substrate W (or substrate holder WT) to clamp it. Electrostatic clamping may, therefore, be used. In electrostatic clamping, a potential difference is established between the substrate W and the substrate holder WT. The potential difference may generate a clamping force. Note: the same applies accordingly for the patterning device MA supported by the reticle stage MT. The forces experienced by the patterning device MA may even be higher, as the accelerations induced by the reticle stage MT may even be higher than those induced by the substrate holder WT, as a result of the optical reduction factor.

By way of example of an object support (e.g., a substrate holder WT or a reticle stage MT), Figure 2 depicts a side view of a highly simplified schematic of an electrostatic object support 201, hereafter an electrostatic clamp, which may form part of an object support for supporting an object 202 (such as a substrate W or reticle MA). The object 202 is disposed on the object support. To maintain the object 202 supported in a stable manner on the support, the clamp 201 provides a clamping force, i.e., the object 202 is attracted onto the object support, for instance, by electrostatic forces. More specifically, the object 202 may be supported on top of the protrusions or burls 204 protruding from the object support 201, such as described with reference to EP0947884, which is incorporated herein by reference.

The electrostatic clamp 201 comprises a stack arranged such that a first or upper surface of electrodes 207, 208, 209 is in contact with a first dielectric (or semi-dielectric) layer 219 and a second surface or lower surface of the electrode is in contact with a second dielectric (or semi-dielectric) layer 221. The dielectric layers 219, 221 are provided in order to maintain a charge provided on at least the first electrode portion 207. In Figure 2, the electrode 207, 208, 209 is depicted in dotted lines in order to indicate that the electrode is disposed within the stack structure of the electrostatic clamp 201. In other words, the electrode is not disposed on an outer surface of the clamp 201. The burls 204 may be integral with the dielectric layer 219. Burls 204 may in that case have a (e.g., conductive) coating 220 such as (e.g., doped) diamond. This top coating 220 provides a relatively hard object support surface layer (hard contact surface). Although not shown, the electrostatic clamp may additionally have burls on the bottom side so as to support and clamp the electrostatic clamp 201 on a support structure such as a position module to move the electrostatic clamp 201, for example relative to a patterned radiation beam B', during use.

It is desirable that the contact surfaces, defined by the burls, together define a contact surface for the object, which is as flat as possible. This contact layer may be comprised of a hard material such as diamond, e.g., mono- or polycrystalline diamond, or other carbon-based material such as diamondlike carbon (DLC). In the context of an electrostatic object support, for example the electrostatic clamp 201 as illustrated by Figure 2, the contact layer may comprise a diamond coating over a dielectric base layer (for other object supports, the base layer may comprise another material), for example coating 220. The (carbon based material) layer comprising a hard material, e.g., diamond or DLC, may have a thickness in the range of 200 nanometers to 6 micrometers, preferably between 2 and 5 micrometers. The hard material layer may be provided by means of a chemical vapor deposition (CVD) process, for example a hot-filament CVD process. The layer may comprise two or more layers, for example, a first layer and a second layer, wherein the second layer is formed on the first layer. Both the first and second layer may be provided by means of a CVD process. The material composition and characteristics of both layers may differ. For a layer comprising diamond, the layer may comprise diamond grains. These diamond grains may be sized between 100 nanometers and 1 micrometer, dependent on the layer thickness and growth conditions, e.g., growth temperature. The hard material may comprise dopants. Providing dopants to the layer, e.g., diamond layer, may enhance the characteristics of the material, for example the hardness, crystallinity, and or resistivity.

To configure (e.g., flatten) this carbon-based material surface, an ion-beam may be used, for example, in an ion beam figuring (IBF) process. The discussion below will refer to a diamond coated contact layer, or more generally a diamond layer, but can be understood to comprise any suitable carbon-based material.

A drawback of known IBF processes is that the ion beam, which is typically high energy, forms an amorphous carbon layer on top of the hard material layer (e.g., the diamond layer). This amorphous carbon (layer, sometimes called soft layer, has a thickness which is not uniform leading to fast initial wear. Because of this, the amorphous carbon layer requires removal e.g., as part of the IBF process using the ion beam. The speed of this amorphous carbon layer removal process is very time-consuming and typically requires two iterations of removal and measurement, i.e., to initially measure the flatness and perform a first removal step and to repeat this to measure and remove the amorphous carbon layer.

One reason for accelerating the ion beam to high energies (e.g., of an order of magnitude of 10 keV) is due to the focusing requirement, whereby the ion beam is to be focused onto the burls. However, even in this case, the ion beam may not be focused down to a region smaller than 1 mm, which is in the same order or more than a typical burl size. That is, burls have typically a width (e.g., diameter) of tens to hundreds or micrometers. For example, the burl may have a diameter in the range of from about 200 micrometer to about 500 micrometer. On top of the burls, for example on top surface of the burls 204 as illustrated in Figure 2, smaller burls (not illustrated) may be provided. These mini-burls may be formed on-top of a base-burl. As these mini-burls are even smaller than the base-burls (for example having a diameter of a few hundreds of micrometers), using the known IBF technique at these mini-burls becomes even more challenging.

Additionally, the etch rate of diamond and the etch rate of a typical dielectric material of a electrostatic clamp (e.g., silicon nitride SiN) is similar. Because of this, significant dielectric material around the burls may also be removed during the burl flattening and amorphous carbon layer removal process. This results in a variation in dielectric thickness and therefore a variation in clamping force, and non-idealities in backfill gas flow from a backfill gas system (backfill gas may be provided between support and object to improve thermal conductivity conditions during clamping).

While the foregoing paragraph describes a particular issue relating to configuring the contact layer of an electrostatic object support, the concepts disclosed herein are applicable more generally. For example, while a vacuum or other object support may not comprise a dielectric base layer, it may be desirable not to etch the base layer of any of these supports when configuring the contact layer. The base layer of these supports may comprise, for example, silicon carbide (SiC), SiSiC or more generally a ceramic or glass material. A ceramic containing silicon carbide used as the base material (or as a layer) may be a sintered body or polycrystal of silicon carbide.

Chemical assisted IBF processes are known, typically in the context of etching silicon. In such processes, a chemical assistant (e.g., a reactive gas) may be provided in the etching chamber which significantly increases the etching rate. However, simply providing a chemical assistant for diamond removal is largely ineffective at increasing removal speed.

To address these issues, it is proposed to perform object support material removal, such as surface configuring or structuring (e.g., patterning (roughening) or flattening), using a chemically assisted IBF process, whereby a reactive gas is used to chemically assist the IBF process, and wherein one or more optical (electromagnetic) radiation beams are used to locally excite, i.e., photodissociate, the gas only in the one or more regions being treated (i.e., only in the regions being configured/etched).

Such object support material removal or configuring may, for example, comprise burl surface flattening (i.e., the removal regions are burl top surfaces), and in particular the material being flattened and removed may comprise diamond or other carbon-based material. However, this is only one specific application, and the methods disclosed herein may be used to configure other removal regions. For example, the method may comprise illuminating regions between burls in order enhance etching at those regions (e.g., to selectively etch between burls without etching the burls). For example, it may be desirable that the base material/substrate has one or more properties altered or changed by such configuring, e.g., *inter alia* to change (reduce or increase) the surface conductivity or to etch any additional layer, which may be present at these removal regions.

The method may comprise introducing the chemical assistant (e.g., a reactive gas) into the chamber in which the IBF process is being performed and focusing a beam of radiation onto a (e.g., diamond) coated removal region, such as a burl contact surface, that is to be configured (e.g., flattened). The beam of radiation can be focused to an area coincident with the removal region, such that substantially only this removal region is irradiated. The reactive gas photodissociates at the removal region, where the radiation beam is focused, thereby producing projectiles (e.g., ions or radicals). These projectiles are therefore produced (only) locally at the removal region (e.g., burl contact surface). Herewith, they greatly increase the etch rate of the ion beam at a well-defined area. This means that the irradiated burl contact surface (or other removal region) is etched much more quickly than the (nonirradiated) surrounding dielectric (or other base material). Because of this, the material removal or flattening may be performed much more quickly, such that the ion beam removes very little base material (e.g., dielectric) in the time that the burl contact surface has been etched to a desired flatness or roughness.

It can be appreciated that the ion beam is still used to do the physical sputtering, as without physical sputtering the chemical etching rates saturate at quite/very low levels. The ion beam may be a (relative) low energy beam because the focusing requirements are much more relaxed, due to the removal only occurring to a substantial degree in the irradiated region for the proposed removal timescales. Because of the low energy of the proposed ion beam, the amorphous carbon layer (soft layer) will not form, or at least formed in a much smaller amount. This means there may be no need to remove this layer. This has an additional benefit of not requiring the two removal-measurement iterations described above, reducing the metrology overhead by about half (single iteration instead of two iterations). The ion beam energy may be, for example, less than 10 keV, less than 5 keV, less than 2 keV, less than 1 keV, less than 800 eV, less than 600 eV or less than 500 eV (e.g., between 100 and 500 eV).

A further advantage is improved control of the removal process through control of the radiation beam(s) rather than control of the ion beam. A radiation beam is much simpler to control and, as has already been described, to focus onto a small area. In the removal timescales proposed herein, only irradiated areas of the object support will be significantly etched by the ion beam and therefore the etching is effectively controlled via control of the radiation beam.

The radiation beam may comprise visible or higher energy radiation, e.g., red, green, or blue light or light of higher energy. The radiation beam may comprise a wavelength of 750 nm or less, 620 nm or less, 570 nm or less, 520 nm or less for example. Radiation with different wavelengths may be used. For example, the radiation beam may comprise radiation of two or more wavelengths.

The reactive gas may comprise any reactive molecular gas which can be photodissociated to provide (e.g., positive and negative) ions (heterolytic cleavage) or radicals (homolytic cleavage), which facilitate removal/etching. Which mechanism occurs and projectiles generated depends on the wavelength of the radiation beam. Either mechanisms will work and are included in the concepts disclosed herein. Diamond removal will depend on the type of bombardment species. While radicals may be less effective in facilitating removal than ions, the amount generated may be increased during this process, for example, to enhance the removal rate for any amorphous carbon generated after initially etching the diamond. Control of the removal process may also be easier using radicals. The number of radicals (or ions) for dissociation depends on the wavelength and intensity of the radiation, and the concentration of the chemical assistant (e.g., the partial gas pressure) and therefore can be controlled via control of any one or more of these parameters. The yield of photodissociation is typically known for various gas systems.

The gas may comprise for example a halogen compound, e.g., a fluoride, chloride or iodide which photodissociates to provide halogen (e.g., fluorine, chlorine or iodine) ions or radicals. A particular example of a suitable compound is xenon difluoride. Other examples include molecular chlorine gas, hydrogen iodide and nitrosyl chloride. Alternatively, the molecular gas may comprise a suitable oxide such as nitrogen dioxide, hydrogen peroxide or di-tert-butyl peroxide. These are only examples, and any molecular gas which photodissociates to provide species (e.g., ions or radicals), which facilitate material removal via ion beam can be used. Other homolytic splitting (fission) examples include:
- Chlorine; Cl₂ to 2 Cl·,
- Hydrogen Iodide; HI to H· + I·,
- Nitrosyl Chloride; NOCl to NO· + Cl· (e.g., using radiation wavelength(s) in the range 254-635 nm),
- Nitrogen Dioxide NO₂ to NO· + O(³P) (e.g., using radiation wavelength(s) in the range 270-360 nm),
- Hydrogen Peroxide H₂O₂ to 2 HO· (using, e.g., 254 nm radiation),
- Di-tert-butyl Peroxide (CH₃)₃-C-O-O-C-(CH₃)₃ to 2 (CH₃)₃-C-O· (using, e.g., 254 nm radiation for symmetric splitting or 193nm radiation for asymmetric splitting),
- Di-tert-butyl Peroxide (CH₃)₃-C-O-O-C-(CH₃)₃ to (CH₃)₃-C· +(CH₃)₃-C-O-O· (e.g., using radiation wavelength(s) in the range 270-360 nm).
A mixture of reactive molecular gases may be used. To photodissociate the gas mixture, radiation with a single wavelength or radiation having a plurality of wavelengths may be used.

Optionally, the temperature of the object support (e.g., the burl contact surfaces) and/or pressure of the reactive gas may be controlled to facilitate formation of an adsorbed monolayer of the (e.g., condensed) reactive gas molecules on the surfaces being treated (i.e., the burl contact surfaces). In particular the object support temperature may be lowered to initiate monolayer adsorption on the burl surfaces that are to be treated, without need of the gas to be of a high pressure. This adsorbed monolayer further facilitates the photodissociation of the chemical assistant.

The ion beam may be, for example, a positive ion beam; e.g., an argon ion beam or other noble ion beam.

A proposed object support material removal (e.g., surface flattening) apparatus may comprise an ion beam source, a radiation source, a chemical assistant source and a chamber for receiving an object, wherein the chemical assistant source is operable to provide a chemical assistant within the chamber (e.g., as a backfill gas), the radiation source is operable to generate a beam of radiation to locally photodissociate the chemical assistant only in one or more removal regions of said object, said one or more removal regions comprising regions of the object from which material is to be removed. The ion beam source is operable to generate one or more ion beams at the one or more removal regions to remove material from the object at the one or more removal regions (e.g., burl contact surfaces). The object support material removal apparatus may be configured such that at least one of the one or more ion beams and the one or more radiation beams act simultaneously on one or more removal regions (i.e., such that the ion beam acts on one or more irradiated removal regions). The proposed module may be configured to perform the methods disclosed herein.

In a simplest example, the ion beam source may generate one ion beam and the radiation source may generate one radiation beam, such that the beams together irradiate and bombard with ions a removal region. The ion beam may be relatively unfocused such that it bombards more than one removal region at any one time. In such an example, the radiation beam source may generate more than one radiation beam to irradiate all the removal regions being bombarded simultaneously. Alternatively, the ion beam source may generate multiple ion beams, with the radiation source operable to generate respective beams for each removal region being bombarded by the multiple ion beams. As such, each (at least one) radiation beam may overlap an ion beam at respective (at least one) removal regions.

The object support material removal apparatus may comprise a temperature conditioning arrangement (e.g., cooling module) for temperature conditioning (e.g., cooling the object being treated) the object support. A pressure regulation arrangement may also be provided for control of the chemical assistant partial pressure within the chamber. The temperature conditioning and/or pressure regulation arrangements may be configured to promote adsorption (e.g., monolayer adsorption) of the chemical assistant on at least the surface of the removal regions.

As radicals are (in some examples) formed in the chamber during the process, the chamber may also optionally comprise a radical getter pump. The radical getter pump may be arranged near the IBF filament in order to scavenge unwanted radicals and to protect the filaments.

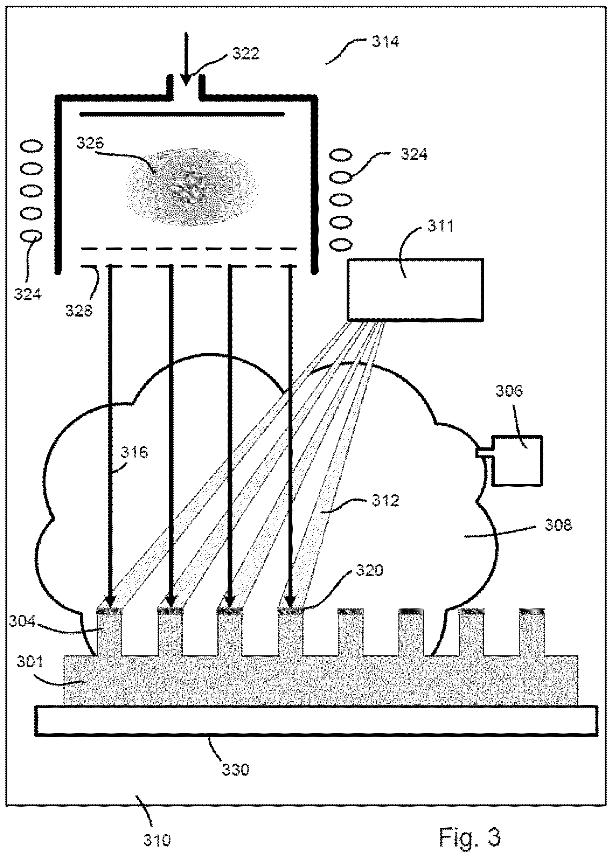

Figure 3 is a simplified schematic illustration of a material removal apparatus and material removal method. An object support 301 (e.g., the object support 201 of Figure 2 or otherwise) comprises burls 304 having, for example, a diamond coating 320 thereon. Each burl 304 contact surface (i.e., the diamond coated surface 320) may define a contact surface for an object (e.g., substrate or reticle) and therefore each define a respective removal region to be treated (etched), for example, flattened.

A chemical assistant supply (gas supply) 306 provides a chemical assistant or gas 308 within a chamber 310 (e.g., removal or etching chamber). A radiation source 311 (e.g., radiation beam module) provides one or more radiation beams 312, which are focused on (and therefore irradiate) substantially only the removal regions that are to be etched (i.e., one or more burl 304 contact surfaces). The gas 308 irradiated in the region of the burl contact surfaces will photodissociate to provide assistant ions or radicals. For example, where the gas is xenon difluoride, fluorine ions or fluorine radicals may be generated at these regions. The radiation beams 312 are focused and controlled such that substantially only the (e.g., diamond) coated contact surfaces 320 are irradiated, and therefore substantially no adjacent dielectric region is irradiated. As stated, the beams may be controlled to irradiation other removal regions, e.g., to etch between burls.

The radiation source 311 may be operable to focus each said at least one radiation beam to a spot at the removal region. The spot may have a size of, for example, 500 micrometer or smaller in diameter, or smaller than 250 micrometer in diameter on said object (e.g., a spot equal to or smaller than 200 µm on said object). The spot of the radiation beam may be circular shaped. The spot of the radiation beam may be line shaped, with a length of 500 micrometers or less. The spot of the radiation beam may have a curved shape, with a length of 500 micrometer or less. A line-shaped or a curve-shaped spot may be used to match the local geometry of the surface or region that is being treated (etched). In general, the spot of the radiation beam may have any shape that is advantageous for the material removal process.

An ion beam source 314 (e.g., argon ion beam source) generates one or more ion beams 316 (e.g., argon ion beams), which acts upon (bombards with ions) the irradiated regions comprising assistant ions or radicals, thereby etching and structuring (e.g., flattening or roughening) these surfaces much faster than without chemical assistance. The ion beam source 314 will not be described in detail, as such sources and how they operate are well known. Any suitable ion beam source may be used. Briefly, the ion beam source may comprise a gas inlet 322 for receiving an atomic gas (e.g., a noble gas such as argon), an RF coil 324 which turns the gas into plasma 326, thereby generating the argon ions. These argon ions are then accelerated toward the target (object support) by an accelerator grid 328.

The material removal apparatus may comprise a temperature regulation arrangement 330 (e.g., any suitable temperature regulating arrangement, which here is schematically represented by box 330) for controlling the temperature of the object support (e.g., cooling the object). Cooling the object support during the treatment may encourage a monolayer coverage of the chemical assistant to form on the (e.g., diamond) surface 320, which is being etched. Alternatively, or in addition, gas source 306 and/or chamber 310 may have a pressure regulation arrangement to regularize the partial gas pressure to help achieve the same aim.

The material removal apparatus may be configured to direct the one or more ion beams 316 and the one or more radiation beams 312 in synchronization over the surface to remove material from at least some of a plurality of removal regions sequentially. For example, where there is only one radiation beam 312 and ion beam 316, or where the number of radiation beams 312 and ion beams 316 are fewer than the number of removal regions, a subset of removal regions (comprising one or more removal regions) may be configured by overlapping a radiation beam 312 and an ion beam 316 respectively at each removal region of the subset. After this, the one or more ion beams 316 and the one or more radiation beams 312 may be moved substantially in synchronization to another subset of removal regions, such that each subset is configured in sequence.

A skilled person in the art will appreciate that any object support such as any wafer table WT or any reticle support MT may benefit from having its (e.g., carbon based coated) contact surface treated (e.g., flattened) using the methods described herein. As such, vacuum object supports and electrostatic object supports may benefit from the concepts disclosed herein. The methods may be particularly beneficial for electrostatic supports as known flattening processes are also etching the dielectric, resulting in an uneven dielectric thickness and therefore clamping strength over the object. This can induce distortions in the object thereby affecting imaging performance.

Compared to known flattening methods, the proposed method can be expected to remove the hard material (e.g., diamond) locally at a rate possibly 10 times or more faster, which means that the etching of dielectric will be minimal during the removal process. Additionally, this speed increase may be achieved with a low energy ion beam, resulting in little or no formation of an amorphous carbon layer and therefore no need for an iterative measure and remove process. Hence, the time required for the manufacturing process is reduced.

As one or more radiation beams are used, a 'light pattern' can be provided at the area of interest. Herewith, the etching process is (mainly) promoted at the pattern area. This provides an opportunity to configure or structure the irradiated surface, e.g., to impose a configuration other than flattening.

The chemical assistant supply 306 may comprise one or more nozzles that are arranged to provide the chemical assistant (gas) 308 locally. For example, the chemical assistant 308 is provided by the one or more nozzles in the vicinity of the area of interest. Herewith, the efficiency of the gas usage is improved. By controlling the gas temperature, and herewith the temperature at the region of interest, the etching process may further be enhanced.

One or more material extraction ports may be provided near the etching area, arranged to remove (or extract) material during the material removal process. Herewith, avoiding or reducing debris (removed material) to interfere the etching process.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Embodiments include the following numbered clauses:
1. A material removal apparatus, comprising:
   a chamber for receiving an object from which material is to be removed;
   a chemical assistant source being operable to provide at least one chemical assistant within the chamber;
   a radiation source for generating at least one radiation beam for locally photodissociating the at least one chemical assistant at one or more removal regions of said object; and
   an ion beam source for providing at least one ion beam at the one or more removal regions to remove material from said one or more removal regions.
2. A material removal apparatus of clause 1, configured such that at least one of the one or more ion beams and at least one of the one or more radiation beams act simultaneously on the one or more removal regions.
3. A material removal apparatus of clause 1 or 2, wherein the ion beam source generates one or more noble gas ion beams.
4. A material removal apparatus of any preceding clause, wherein the ion beam source generates one or more argon ion beams.
5. A material removal apparatus of any preceding clause, wherein said radiation source is operable to generate the one or more radiation beams to comprise a wavelength of 750 nm or smaller.
6. A material removal apparatus of any preceding clause, comprising a temperature regulation arrangement for regulating a temperature of said object and or chemical assistant thereby promoting adsorption of a monolayer of said chemical assistant on said one or more removal regions.
7. A material removal apparatus of clause 6, wherein the temperature regulation arrangement is operable to lower a temperature of said object.
8. A material removal apparatus of any preceding clause, wherein the at least one chemical assistant comprises a reactive gas.
9. A material removal apparatus of any preceding clause, wherein the reactive gas comprises a halogen compound or oxygen compound.
10. A material removal apparatus of any preceding clause, wherein the reactive gas comprises an oxide, peroxide, iodide, fluoride or chloride.
11. A material removal apparatus of any preceding clause, wherein the reactive gas comprises xenon difluoride, nitrogen dioxide, molecular chlorine, hydrogen iodide, nitrosyl chloride, hydrogen peroxide or di-tert-butyl peroxide.
12. A material removal apparatus of any preceding clause, comprising a pressure regulation arrangement operable to regulate a partial pressure of the at least one chemical assistant.
13. A material removal apparatus of any preceding clause, wherein the radiation source is operable to focus each said at least one radiation beam on a respective removal region of said one or more removal regions.
14. A material removal apparatus of any preceding clause, wherein the radiation source is operable to illuminate only said one or more removal regions.
15. A material removal apparatus of any preceding clause, wherein the radiation source is operable to focus each said at least one radiation beam to a spot size of 500 µm or smaller on said object.
16. A material removal apparatus of any preceding clause, wherein the radiation source is operable to focus each said at least one radiation beam to a spot size equal to or smaller than 200 µm on said object.
17. A material removal apparatus of any preceding clause, wherein said material comprises a carbon-based material.
18. A material removal apparatus of any preceding clause, wherein said material comprises diamond, diamond like carbon, or crystalline diamond.
19. A material removal apparatus of any preceding clause, wherein said object comprises an object support, and said apparatus is configured for flattening and/or configuring one or more contact surfaces of the object support.
20. A material removal apparatus of clause 19, wherein said one or more contact surfaces comprise one or more burl top surfaces of the object support.
21. A material removal apparatus of clause 19 or 20, wherein the object support comprises a substrate support or a reticle support for a lithographic apparatus.
22. A material removal apparatus of any of clauses 19 to 21, wherein the object support comprises an electrostatic object support.
23. A material removal apparatus of any preceding clause, wherein said ion beam source is operable to generating each said at least one ion beam to have an energy less than 10 keV.
24. A material removal apparatus of any preceding clause, wherein said ion beam source is operable to generating each said at least one ion beam to have an energy less than 1 keV.
25. A material removal apparatus of any preceding clause, wherein said ion beam source is operable to generating each said at least one ion beam to have an energy less than 500 eV.
26. A material removal apparatus of any preceding clause, configured such that at least one of the one or more ion beams and the one or more radiation beams are controllable to overlap at the one or more removal regions.
27. A material removal apparatus of any preceding clause, configured to direct the one or more ion beams and the one or more radiation beams in synchronization over the surface to remove material from at least some of a plurality of removal regions sequentially.
28. A method for removing material from one or more removal regions on an object support, comprising:
   providing a chemical assistant to a chamber comprising the object support;
   irradiating said one or more removal regions to locally photodissociate the chemical assistant at the one or more removal regions of said object support;
   generating at least one ion beam; and
   directing the at least one ion beam at the one or more removal regions to remove material from said one or more removal regions.
29. A method of clause 28, wherein said irradiating said one or more removal regions and directing at least one of the one or more ion beams at the one or more removal regions is done simultaneously.
30. A method of clause 28 or 29, wherein said irradiating said one or more removal regions comprises directing one or more radiation beams such that, each said one or more radiation beams overlaps at least one of said one or more ion beams at the one or more removal regions.
31. A method of clause 30, comprising directing the one or more ion beams and the one or more radiation beams in synchronization over the surface to remove material from at least some of a plurality of removal regions sequentially.
32. A method of clause 30 or 31, comprising focusing each said one or more radiation beams on a respective removal region of said one or more removal regions.
33. A method of any of clauses 30 to 32, comprising focusing each said at least one radiation beam to a spot equal to or smaller than 500 µm on said object support.
34. A method of any of clauses 30 to 33, comprising focusing each said at least one radiation beam to a spot equal to or smaller than 200 µm on said object support.
35. A method of any of clauses 28 to 34, wherein the one or more ion beams comprise one or more noble gas ion beams.
36. A method of any of clauses 28 to 34, wherein the one or more ion beams comprise one or more argon ion beams.
37. A method of any of clauses 28 to 36, wherein said irradiating step uses radiation having a wavelength of 750 nm or smaller.
38. A method of any of clauses 28 to 37, comprising regulating a temperature of said object support and or the chemical assistant to promote adsorption of a monolayer of said chemical assistant on said one or more removal regions.
39. A method of clause 38, comprising lowering the temperature of said object support.
40. A method of any of clauses 28 to 39, wherein the chemical assistant comprises a reactive gas.
41. A method of any of clauses 28 to 40, wherein the reactive gas comprises a halogen compound or oxygen compound.
42. A method of any of clauses 28 to 41, wherein the reactive gas comprises an oxide, peroxide, iodide, fluoride or chloride.
43. A method of any of clauses 28 to 42, wherein the reactive gas comprises xenon difluoride, nitrogen dioxide, molecular chlorine, hydrogen iodide, nitrosyl chloride, hydrogen peroxide or di-tert-butyl peroxide.
44. A method of any of clauses 28 to 43, comprising regulating a pressure of the chemical assistant to promote adsorption of a monolayer of said chemical assistant on said one or more removal regions.
45. A method of any of clauses 28 to 44, comprising focusing each said at least one radiation beam on a respective removal region of said one or more removal regions.
46. A method of any of clauses 28 to 45, wherein said irradiating step comprises irradiating only said one or more removal regions.
47. A method of any of clauses 28 to 46, wherein said material comprises a carbon-based material.
48. A method of any of clauses 28 to 46, wherein said material comprises diamond, diamond like carbon, or crystalline diamond.
49. A method of any of clauses 28 to 48, wherein each said at least one ion beam comprises an energy less than 10 keV.
50. A method of any of clauses 28 to 48, wherein each said at least one ion beam comprises an energy less than 1 keV.
51. A method of any of clauses 28 to 48, wherein each said at least one ion beam comprises an energy less than 500 eV.
52. A method of any of clauses 28 to 51, comprising flattening and/or configuring one or more contact surfaces of the object support.
53. A method of clause 52, wherein said one or more contact surfaces comprise one or more burl top surfaces of the object support.
54. A method of any of clauses 28 to 52, comprising configuring one or more regions between burls of the object support.
55. A method of any of clauses 28 to 54, wherein the object support comprises a substrate support or a reticle support for a lithographic apparatus.
56. A method of any of clauses 28 to 55, wherein the object support comprises an electrostatic object support.
57. An object support comprising one or more contact surfaces having been flattened and/or configured using the method of any of clauses 28 to 56.
58. A material removal apparatus of any of clause 1 to 27, comprising a radical getter pump.
59. A material removal apparatus of any of clause 1 to 27 and 58, wherein the chemical assistant source comprises one or more nozzles arranged to provide the chemical assistant at the removal regions.
60. A material removal apparatus of any of clause 1 to 27, 58 and 59, comprising one or more extraction ports arranged to extract material during the material removal process.

## Claims

1. A material removal apparatus, comprising:
a chamber for receiving an object from which material is to be removed;
a chemical assistant source being operable to provide a chemical assistant within the chamber;
a radiation source for generating at least one radiation beam for locally photodissociating the chemical assistant at one or more removal regions of said object; and
an ion beam source for providing at least one ion beam at the one or more removal regions to remove material from said one or more removal regions.

2. A material removal apparatus as claimed in claim 1, configured such that at least one of the one or more ion beams and at least one of the one or more radiation beams act simultaneously on the one or more removal regions.

3. A material removal apparatus as claimed in claim 1 or 2, wherein the ion beam source generates one or more noble gas ion beams.

4. A material removal apparatus as claimed in any preceding claim, wherein said radiation source is operable to generate the one or more radiation beams to comprise a wavelength of 750 nm or smaller.

5. A material removal apparatus as claimed in any preceding claim, comprising a temperature regulation arrangement for regulating a temperature of said object thereby promoting adsorption of a monolayer of said chemical assistant on said one or more removal regions.

6. A material removal apparatus as claimed in any preceding claim, wherein the chemical assistant comprises a reactive gas.

7. A material removal apparatus as claimed in any preceding claim, comprising a pressure regulation arrangement operable to regulate a partial pressure of the chemical assistant.

8. A material removal apparatus as claimed in any preceding claim, wherein the radiation source is operable to focus each said at least one radiation beam to a spot size of 500 µm or smaller on said object.

9. A material removal apparatus as claimed in any preceding claim, wherein said object comprises an object support, and said apparatus is configured for flattening and/or configuring one or more contact surfaces of the object support.

10. A method for removing material from one or more removal regions on an object support, comprising:
providing a chemical assistant to a chamber comprising the object support;
irradiating said one or more removal regions to locally photodissociate the chemical assistant at the one or more removal regions of said object support;
generating at least one ion beam; and
directing the at least one ion beam at the one or more removal regions to remove material from said one or more removal regions.

11. A method as claimed in claim 10, wherein said irradiating said one or more removal regions and directing at least one of the one or more ion beams at the one or more removal regions is done simultaneously.

12. A method as claimed in claim 10 or 11, wherein said irradiating said one or more removal regions comprises directing one or more radiation beams such that, each said one or more radiation beams overlaps at least one of said one or more ion beams at the one or more removal regions.

13. A method as claimed in any of claims 10 to 12, wherein the one or more ion beams comprise one or more noble gas ion beams.

14. A method as claimed in any of claims 10 to 12, comprising regulating a temperature of said object support to promote adsorption of a monolayer of said chemical assistant on said one or more removal regions.

15. A method as claimed in any of claims 10 to 12, comprising flattening and/or configuring one or more contact surfaces of the object support.
